# DEMANDE DE BREVET EUROPEEN

(11) **EP 4 498 786 A1**
(43) Date de publication de la demande: **29.01.2025**
(21) Numéro de dépôt: 24189823.8
(22) Date de dépôt: 19.07.2024
(51) Int. Cl.: H10N 70/00, H10N 70/20, H10B 63/00, H10B 63/10

(54) **PROCEDE DE FABRICATION D'UN COMPOSANT ELECTRONIQUE**

(30) Priorité: 24.07.2023 FR 2307957
(71) Demandeur: Commissariat à l'Energie Atomique et aux Energies Alternatives, 75015 Paris (FR)
(72) Inventeur: BOIXADERAS, Christelle, 38054 GRENOBLE CEDEX 09 (FR); POSSEME, Nicolas, 38054 GRENOBLE CEDEX 09 (FR); FONTAINE, Benjamin, 38920 CROLLES (FR); DUBOIS, Jerome, 38920 CROLLES (FR); GOURAUD, Pascal, 38920 CROLLES (FR)
(74) Mandataire: Cabinet Beaumont

(57) **Abrégé**

La présente description concerne un procédé de fabrication d'un composant électronique comprenant une étape a) de gravure d'au moins une première couche (104) en un matériau à base de germanium et comprenant un élément parmi l'oxygène, le soufre, le sélénium et le tellure suivie, sans remise en contact avec de l'oxygène, d'une étape b) de traitement des flancs (104f) gravés de la première couche (104), par un plasma d'hydrogène.

## Description

### Domaine technique

La présente description concerne de façon générale les procédés de fabrication de composants électroniques et plus particulièrement les procédés de fabrication des cellules mémoires non volatiles à changement de phase (ou PCM de l'anglais "Phase Change Memory") ou des cellules de commutation à seuil ovonique (OTS, de l'anglais "Ovonic Threshold Switching).

### Technique antérieure

Les mémoires à changement de phase ou PCM sont des mémoires non volatiles s'appuyant sur les propriétés des matériaux à changement de phase. Un matériau à changement de phase est un matériau ayant la capacité de changer d'état sous l'effet de la chaleur et plus particulièrement de commuter entre un état cristallin et un état amorphe, plus fortement résistif que l'état cristallin. Les mémoires à changement de phase tirent profit du fait que les résistances électriques de la phase amorphe des matériaux à changement de phase et celles de la phase cristalline sont différentes afin de stocker des données.

Les cellules OTS s'appuient quant à elles sur la capacité du matériau qui la compose de changer d'état en fonction de la quantité de potentiel de tension appliqué aux bornes de la cellule.

Il existe un besoin d'amélioration des procédés de fabrication des cellules mémoires et à commutation.

### Résumé de l'invention

Un mode de réalisation prévoit un procédé de fabrication d'un composant électronique comprenant une étape a) de gravure d'au moins une première couche en un matériau à base de germanium et comprenant un élément parmi l'oxygène, le soufre, le sélénium et le tellure suivie, sans remise en contact avec de l'oxygène, d'une étape b) de traitement des flancs gravés de la première couche, par un plasma d'hydrogène.

Selon un mode de réalisation, la première couche est un matériau chalcogénure.

Selon un mode de réalisation, la première couche est située dans un empilement comportant une couche conductrice et un élément résistif entouré d'une couche isolante, la première couche étant en contact par une première face avec la couche conductrice et par une deuxième face, opposée à la première face, avec l'élément résistif.

Selon un mode de réalisation, la première couche est en un matériau à changement de phase.

Selon un mode de réalisation, l'empilement comporte une deuxième couche en un matériau de commutation à seuil ovonique et une autre couche conductrice, la deuxième couche conductrice étant en contact par une première face avec la couche conductrice et par une deuxième face, opposée à la première face, avec l'autre couche conductrice.

Selon un mode de réalisation, la première couche est en un matériau de commutation à seuil.

Selon un mode de réalisation, l'étape de gravure de la première couche correspond à une gravure plasma halogénée.

Selon un mode de réalisation, la première couche est à base de tellure.

Selon un mode de réalisation, la première couche consiste en un alliage de germanium, de tellure et d'antimoine.

Selon un mode de réalisation, la première couche est à base de sélénium, par exemple à base d'antimoine, de sélénium et de germanium.

Selon un mode de réalisation, la tension de polarisation continue ou pulsée est inférieure à 100 V, par exemple inférieure à 10 V en valeur absolue, par exemple inférieure à 1 V en valeur absolue, par exemple nulle.

Selon un mode de réalisation, le plasma comporte du dihydrogène ou de l'ammoniac, le flux de chaque gaz du plasma étant compris entre 25 cm³/min et 500 cm³/min.

Selon un mode de réalisation, la puissance de la source plasma est comprise entre 200 W et 1000 W et la pression appliquée dans le réacteur est comprise entre 0,4 Pa et 13,3 Pa.

Selon un mode de réalisation, l'étape de gravure est une étape de gravure plasma halogénée.

Selon un mode de réalisation, à l'étape a), la gravure est réalisée à travers un masque de gravure préalablement déposé sur la première couche, le traitement des flancs appliqué lors de l'étape b) conduisant au retrait dudit masque de gravure.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1A, la figure 1B, la figure 1C et la figure 1D représentent des vues en coupe, partielles et schématiques, d'étapes successives d'un exemple de réalisation d'un procédé de fabrication d'un composant électronique ; et

la figure 2A, la figure 2B, la figure 2C, la figure 2D et la figure 2E représentent des vues en coupe, partielles et schématiques, d'étapes successives d'un procédé de fabrication d'un composant électronique selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, le procédé de fabrication d'une unique cellule mémoire a été représenté, les modes de réalisation décrits sont toutefois applicables à la fabrication simultanée de multiples cellules organisées en réseau sur une même plaque. De plus, des connexions électriques entre les cellules, et des circuits de sélection composant le circuit mémoire n'ont pas été détaillées, les modes de réalisation décrits étant compatibles avec des circuits de sélections usuels ainsi que leurs circuits d'adressage correspondants.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

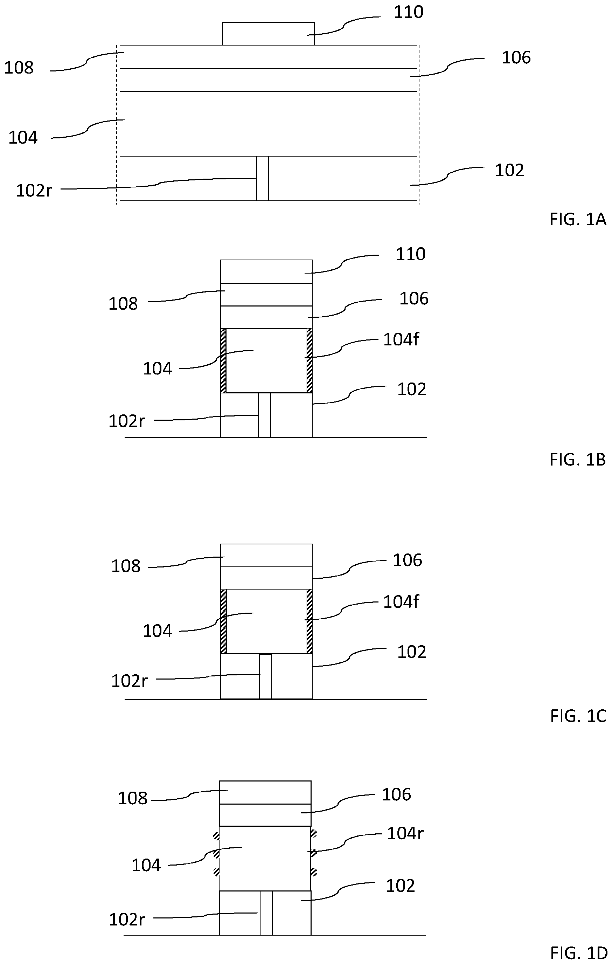

La figure 1A, la figure 1B, la figure 1C et la figure 1D représentent des vues en coupe, partielles et schématiques, d'étapes successives d'un exemple de réalisation d'un procédé de fabrication d'une cellule mémoire à changement de phase.

La figure 1A illustre une structure de départ comportant une couche isolante 102 et un élément résistif chauffant 102r aussi appelé "heater" en anglais, s'étendant verticalement dans la couche isolante 102. A titre d'exemple, l'élément résistif 102r est entouré latéralement par la couche isolante 102. La couche isolante 102 permet par exemple d'isoler et séparer latéralement l'élément résistif 102r d'un autre élément résistif 102r voisin (non visible sur les figures). A titre d'exemple, l'élément résistif 102r affleure, par sa face supérieure, la face supérieure de la couche isolante 102, et, par sa face inférieure, la face inférieure de la couche isolante 102.

La structure de départ comporte, de plus, une couche 104 en un matériau à base de germanium et d'un élément de la colonne seize du tableau périodique.

A titre d'exemple, la couche 104 est en un matériau chalcogénure. A titre d'exemple, la couche 104 est en un matériau à changement de phase dite couche PCM ("phase change material"). A titre d'exemple la couche PCM 104 est en un matériau à base de germanium et de tellure. En variante, la couche PCM 104 est en un matériau à base de germanium et de sélénium. Par exemple, la couche PCM 104 est à base d'un alliage de germanium, d'antimoine et de tellure ou GST (de l'anglais "germanium antimony tellurium").

En variante, la couche 104 est en un matériau OTS.

La couche PCM 104 est, par exemple, formée sur la face supérieure de la couche isolante 102 et de l'élément résistif 102r. La couche PCM 104 est par exemple en contact, par sa face inférieure, avec la face supérieure de la couche isolante 102 et de l'élément résistif 102r. A titre d'exemple, la couche PCM 104 s'étend sur toute la surface de la face supérieure de la couche isolante 102.

La structure de départ comporte, encore, une couche conductrice 106. La couche conductrice 106 est, par exemple, formée sur la face supérieure de la couche PCM 104. La couche conductrice 106 est par exemple en contact, par sa face inférieure, avec la face supérieure de la couche PCM 104. A titre d'exemple, la couche conductrice 106 s'étend sur toute la surface de la face supérieure de la couche PCM 104. A titre d'exemple, la couche conductrice 106 correspond à l'électrode supérieure de la cellule mémoire formée lors des étapes suivantes.

La structure de départ comporte, en outre, une couche isolante 108. La couche isolante 108 est, par exemple, formée sur la face supérieure de la couche conductrice 106. La couche isolante 108 est par exemple en contact, par sa face inférieure, avec la face supérieure de la couche conductrice 106. A titre d'exemple, la couche isolante 108 s'étend sur toute la surface de la face supérieure de la couche conductrice 106.

La couche isolante 108 est, par exemple, recouverte par un masque de gravure 110. Le masque de gravure 110 est par exemple formé sur et en contact avec la face supérieure de la couche isolante 108. Le masque de gravure 110 ne s'étend par exemple pas sur toute la surface de la face supérieure de la couche 108. Le masque de gravure 110 est par exemple formé en vis-à-vis de l'emplacement souhaité pour la cellule mémoire.

Bien que non visible sur les figures, l'empilement formé par les couches 102, 104, 106, 108, 110 repose par exemple sur et en contact avec la face supérieure d'un circuit intégré de contrôle, comprenant un ou plusieurs dispositifs de sélection des cellules mémoire à changement de phase. A titre d'exemple, les éléments de sélection sont des transistors, des diodes, ou des éléments OTS.

La figure 1B illustre une structure obtenue à l'issue d'une étape de gravure de l'empilement formé par la couche isolante 102, la couche PCM 104, la couche conductrice 106 et la couche isolante 108.

Lors de cette étape, les parties des couches 102, 104, 106, 108 non protégées par le masque de gravure 110 sont retirées. La gravure de ces couches comprend entre autres une étape de gravure plasma halogénée. A titre d'exemple, la gravure halogénée est réalisée à l'aide de bromure d'hydrogène (HBr), du dichlore, (Cl₂), du tétrafluorométhane (CF₄), du fluorométhane (CFₓ, dans lequel x est compris entre 0,1 et 4).

A titre d'exemple, lors de cette étape, la couche PCM 104 a ses flancs 104f davantage modifiés que les couches 102, 106 et 108.

Lors de cette étape, les flancs 104f de la couche PCM 104 s'enrichissent en atomes d'halogène au niveau de ses flancs 104f. A titre d'exemple, la couche PCM 104 est enrichie sur une épaisseur comprise entre 1 nm et 20 nm, par exemple comprise entre 1 nm et 10 nm. A titre d'exemple, les flancs 104f de la couche PCM 104 comportent à l'issue de cette étape, un pourcentage d'halogène, par exemple dans les vingt premiers nanomètres, compris entre 1 % et 30 %.

A titre d'exemple, dans le cas où la couche PCM 104 est en un matériau chalcogénure à base de tellure, lors de cette étape, les flancs 104f de la couche PCM 104 se voient en outre enrichis en tellure.

La figure 1C illustre une structure obtenue à l'issue d'une étape de retrait du masque de gravure 110.

Le retrait du masque 110 est par exemple effectué par une étape de gravure plasma à base d'oxygène dite de "stripping".

A titre d'exemple, les étapes illustrées en figures 1B et 1C sont réalisées sous une pression par exemple inférieure à 100 Pa, par exemple inférieure à 1 Pa. A titre d'exemple, les étapes des figures 1B et 1C sont réalisées au sein d'un même équipement. A titre d'exemple, à l'issue de l'étape illustrée en figure 1B, la structure n'est pas remise en contact avec de l'oxygène avant l'étape illustrée en figure 1C.

La figure 1D illustre une structure obtenue à l'issue d'une étape de nettoyage de la structure illustrée en figure 1C.

L'étape de nettoyage illustrée en figure 1D est par exemple réalisée par un traitement chimique par voie humide. A titre d'exemple, le nettoyage est réalisé à base d'acide fluorhydrique et d'acide glycolique.

Cette étape de nettoyage est par exemple réalisée alors que la structure a été remise à l'air, c'est-à-dire que qu'elle est réalisée sous pression atmosphérique et que la structure n'est plus sous vide ou sous atmosphère inerte. Lors de la remise à l'air et lors de cette étape, les atomes d'halogène présents dans les flancs 104f de la couche 104 se voient alors dégazés, c'est-à-dire qu'ils ressortent de la structure. A titre d'exemple, en dégazant, les atomes d'halogène réagissent avec l'air et forment à la surface des flancs 104f des résidus 104r. A titre d'exemple, les résidus 104r peuvent avoir des dimensions allant jusqu'à 300 nm, par exemple jusqu'à 200 nm. A titre d'exemple, lors de cette étape, de l'oxyde de germanium, issu de la réaction entre le germanium présent dans la couche PCM 104, dont la surface a été altérée lors de l'étape de nettoyage illustrée en figure 1C, et de l'oxygène présent dans l'air, est en outre formé sur les flancs 104f de la couche PCM 104.

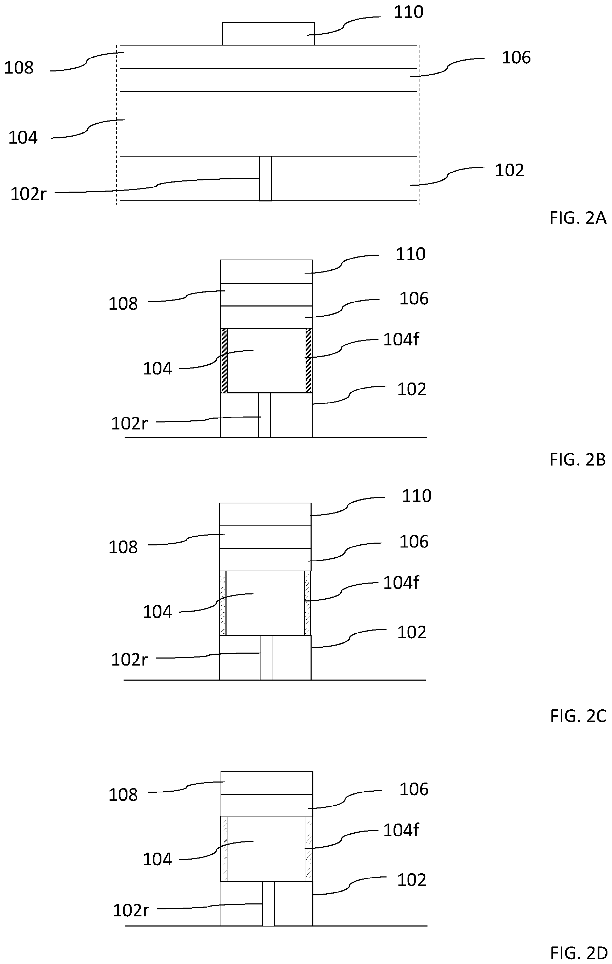

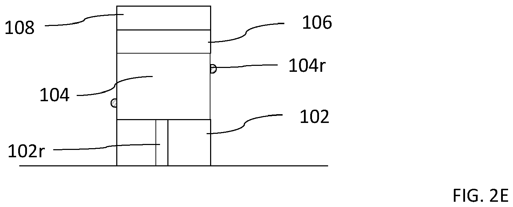

La figure 2A, la figure 2B, la figure 2C, la figure 2D et la figure 2E représentent des vues en coupe, partielles et schématiques, d'étapes successives d'un procédé de fabrication d'un composant électronique selon un mode de réalisation.

La figure 2A illustre plus particulièrement une structure de départ identique à la structure de départ illustrée en figure 1A.

L'épaisseur de la couche PCM 104 est par exemple comprise entre 30 nm et 100 nm, par exemple comprise entre 40 nm et 60 nm.

La couche conductrice 106 est par exemple en métal, par exemple en un alliage à base de titane. L'épaisseur de la couche conductrice 106 est par exemple comprise entre 5 nm et 40 nm, par exemple comprise entre 15 nm et 30 nm.

La couche isolante 108 est par exemple en nitrure de silicium. L'épaisseur de la couche isolante 108 est par exemple comprise entre 5 nm et 40 nm, par exemple comprise entre 15 nm et 30 nm.

Le masque 110 est par exemple en carbone. Le masque 110 a par exemple une épaisseur comprise entre 200 nm et 400 nm, par exemple comprise entre 250 nm et 300 nm.

La figure 2B illustre une structure obtenue à l'issue d'une étape de gravure de l'empilement formé par la couche isolante 102, la couche PCM 104, la couche conductrice 106 et la couche isolante 108. Cette étape est identique à celle illustrée en figure 1B. A titre d'exemple, cette étape est réalisée dans un réacteur à plasma à couplage capacitif (CCP, de l'anglais "capacitively coupled plasma") ou dans un réacteur à plasma à couplage inductif (ICP, de l'anglais "inductively coupled plasma").

La figure 2C illustre une structure obtenue à l'issue d'une étape de traitement des flancs 104f gravés de la couche PCM 104. Cette étape est réalisée à l'issue de l'étape illustrée en figure 2C sans que la structure ne soit remise en contact avec de l'oxygène.

A titre d'exemple, les étapes illustrées en figures 2B et 2C sont réalisées au sein d'un même équipement.

Cette étape est réalisée par un plasma à base d'hydrogène. A titre d'exemple, le plasma est composé de dihydrogène ou d'ammoniac, par exemple avec un ou des gaz neutres comme de l'argon ou du diazote. Les gaz neutres peuvent, dans le plasma, aider à l'allumage et à la stabilité du plasma. En tout état de cause, le plasma utilisé à cette étape ne comprend pas d'oxygène.

Lors de cette étape, les liaisons formées au niveau des flancs 104f, entre les atomes d'halogène et les éléments de la couche PCM 104, sont cassées et les atomes d'halogène liés sur les flancs 104f de la couche PCM 104 sont en partie retirés. Ces atomes sont par exemple remplacés par des atomes d'hydrogène qui se lient à leur tour sur les flancs 104f de la couche 104. On parle ici de rétablissement de l'état de surface de la couche 104.

Lors de cette étape, la tension de polarisation continue ou pulsée appliquée au plasma, aussi appelée bias, est relativement faible, par exemple inférieure à 100 V en valeur absolue. A titre d'exemple, lors de cette étape, la tension de polarisation continue est inférieure à 10 V en valeur absolue. A titre d'exemple, lors de cette étape, la tension de polarisation continue est inférieure à 1 V en valeur absolue. De préférence, lors de cette étape, la tension de polarisation continue est nulle. Cette faible valeur de bias permet notamment de ne pas consommer une quantité trop importante des flancs 104f de la couche PCM 104.A titre d'exemple, en polarisation pulsée, le rapport cyclique ("duty cycle" en anglais) de polarisation, c'est à dire le pourcentage de temps pendant lequel la tension de polarisation est appliquée au substrat est compris entre 20 % et 90 % du temps de cycle. A titre d'exemple, en polarisation pulsée, la fréquence de cycle est comprise entre 100 Hz et 5kHz.

A titre d'exemple, le flux de chaque gaz du plasma est compris entre 25 cm³/min et 500 cm³/min. A titre d'exemple, la puissance de la source plasma est comprise entre 200 W et 1000 W. A titre d'exemple, la pression appliquée dans le réacteur est comprise entre 3 mTorr (c'est-à-dire environ 0,4 Pa) et 100 mTorr (c'est-à-dire environ 13,3 Pa). A titre d'exemple, lors de cette étape, la température de la structure est comprise entre 0 °C et 100 °C. A titre d'exemple, cette étape a une durée comprise entre 5 secondes et 30 secondes, par exemple comprise entre 5 et 15 secondes.

Lors de cette étape, outre le retrait des atomes d'halogène dans les flancs 104f de la couche PCM 104, le plasma permet une diminution du pourcentage en tellure dans la couche PCM 104, par exemple de façon homogène dans l'ensemble de la couche PCM 104. A titre d'exemple, cette étape permet en outre le nettoyage des flancs de la couche conductrice 106 sur lesquels des atomes d'halogène peuvent former des résidus lors de la remise à l'ait après l'étape de gravure illustrée en relation avec la figure 2B.

La figure 2D illustre une structure obtenue à l'issue d'une étape de retrait du masque de gravure 110 de la structure illustrée en figure 2C, par exemple identique à l'étape de retrait du masque de gravure 110 illustrée en relation avec la figure 1C. En variante, le retrait du masque de gravure 110 est réalisé lors de l'étape illustrée en relation avec la figure 2C par gravure plasma hydrogène.

La figure 2E illustre une structure obtenue à l'issue d'une étape de nettoyage de la structure illustrée en figure 2D. Cette étape est par exemple similaire à l'étape illustrée en relation avec la figure 1D à la différence près que les flancs 104f de la couche 104 de la structure illustrée en figure 2D comportent moins d'atomes d'halogène que les flancs 104f de la couche 104 de la structure illustrée en figure 1D.

Lors de la remise à l'air après les étapes illustrées par les figures 2B, 2C et 2D et lors de cette étape, des résidus 104r sont alors formés à la surface des flancs 104f de la couche PCM 104 mais dans une proportion moindre par rapport à la proportion de résidus formés lors de l'étape illustrée en figure 1D.

Un avantage du présent mode de réalisation est qu'il permet de prévenir l'apparition de résidus sur les flancs de la couche PCM, contrôler la composition des flancs de la couche PCM et ainsi réduire la rugosité en surface. Ceci permet notamment d'améliorer la fiabilité et la durée de vie des cellules mémoire.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que l'étape de traitement des flancs de la couche PCM par plasma hydrogène soit effectuée entre l'étape de gravure halogénée et l'étape de retrait du masque de gravure, on peut prévoir qu'elle soit réalisée après ou pendant l'étape de retrait du masque de gravure et avant la remise à l'air de la structure.

De plus, on peut prévoir en variante que chaque cellule comporte, au dessus de la couche conductrice 106, un empilement d'une couche en un matériau OTS et une autre couche conductrice. Dans cette variante, la couche OTS est en contact, par sa face inférieure avec la face supérieure de la couche conductrice 106 et l'autre couche conductrice est en contact avec la couche OTS.

Enfin, la mise en oeuvre pratique des modes de réalisation et variantes décrits est à la portée de la personne du métier à partir des indications fonctionnelles données ci-dessus.

## Revendications

1. Procédé de fabrication d'un composant électronique comprenant une étape a) de gravure d'au moins une première couche (104) en un matériau à base de germanium et comprenant un élément parmi l'oxygène, le soufre, le sélénium et le tellure suivie, sans remise en contact avec de l'oxygène, d'une étape b) de traitement des flancs (104f) gravés de la première couche (104), par un plasma d'hydrogène.

2. Procédé selon la revendication 1, dans lequel la première couche (104) est un matériau chalcogénure.

3. Procédé selon la revendication 1 ou 2 dans lequel la première couche est située dans un empilement comportant une couche conductrice (106) et un élément résistif (102r) entouré d'une couche isolante (102), la première couche (104) étant en contact par une première face avec la couche conductrice (106) et par une deuxième face, opposée à la première face, avec l'élément résistif (102r).

4. Procédé selon l'une quelconque des revendications 1 à 3, dans lequel la première couche (104) est en un matériau à changement de phase.

5. Procédé selon les revendications 3 et 4, dans lequel, l'empilement comporte une deuxième couche en un matériau de commutation à seuil ovonique et une autre couche conductrice, la deuxième couche conductrice étant en contact par une première face avec la couche conductrice (106) et par une deuxième face, opposée à la première face, avec l'autre couche conductrice.

6. Procédé selon l'une quelconque des revendications 1 à 3, dans lequel la première couche (104) est en un matériau de commutation à seuil.

7. Procédé selon l'une quelconque des revendications 1 à 6, dans lequel l'étape de gravure de la première couche (104) correspond à une gravure plasma halogénée.

8. Procédé selon l'une quelconque des revendications 1 à 7, dans lequel la première couche (104) est à base de tellure.

9. Procédé selon la revendication 8, dans lequel la première couche (104) consiste en un alliage de germanium, de tellure et d'antimoine.

10. Procédé selon l'une quelconque des revendications 1 à 9, dans lequel la première couche (104) est à base de sélénium, par exemple à base d'antimoine, de sélénium et de germanium.

11. Procédé selon l'une quelconque des revendications 1 à 10, dans lequel la tension de polarisation continue ou pulsée est inférieure à 100 V, par exemple inférieure à 10 V en valeur absolue, par exemple inférieure à 1 V en valeur absolue, par exemple nulle.

12. Procédé selon l'une quelconque des revendications 1 à 11, dans lequel le plasma comporte du dihydrogène ou de l'ammoniac, le flux de chaque gaz du plasma étant compris entre 25 cm³/min et 500 cm³/min.

13. Procédé selon l'une quelconque des revendications 1 à 12, dans lequel la puissance de la source plasma est comprise entre 200 W et 1000 W et la pression appliquée dans le réacteur est comprise entre 0,4 Pa et 13,3 Pa.

14. Procédé selon l'une quelconque des revendications 1 à 13, dans lequel l'étape de gravure est une étape de gravure plasma halogénée.

15. Procédé selon l'une quelconque des revendications 1 à 14, dans lequel, à l'étape a), la gravure est réalisée à travers un masque de gravure (110) préalablement déposé sur la première couche (104), le traitement des flancs appliqué lors de l'étape b) conduisant au retrait dudit masque de gravure (110).
